# EUROPEAN PATENT SPECIFICATION

(11) **EP 1 820 571 B1**
(45) Date of publication and mention of the grant of the patent: **27.05.2009**
(21) Application number: 06002630.9
(22) Date of filing: 09.02.2006
(51) Int. Cl.: B01L 3/00

(54) **3D structures based on 2D substrates**
Auf 2D-Substraten basierende 3D-Strukturen
Structures 3D à base de substrats 2D

(43) Date of publication of application: 22.08.2007
(73) Proprietor: Roche Diagnostics GmbH, 68305 Mannheim (DE); F.HOFFMANN-LA ROCHE AG, 4070 Basel (CH)
(72) Inventor: Sandoz, Roger, 6343 Rotkreuz (CH); Effenhauser, Carlo, 69469 Weinheim (DE)
(74) Representative: Irniger, Ernst

(56) References cited:
- EP-A- 1 120 164
- EP-A- 1 542 010
- US-A- 5 234 813
- US-B1- 6 827 906

## Description

The present invention refers to a micro fluidic device comprising a laminate structure or architecture (both terms shall be used as synonyms hereinafter), respectively, and to a process for the production of such a micro fluidic device.

Besides traditional plane or 2D (for dimensional) micro fluidic devices multilayer micro fluidic devices are known comprising at least one layer with fluidic paths or channels or fluidic structures, respectively. These multilayer devices or the individual layers are produced by means of known techniques such as etching, injection moulding, punching, cutting, etc..

E.g., WO 01/25137 proposes the production of modular 3-dimensional (3D) micro fluidic devices using a plurality of layers, most of which are produced and processed by etching processes known e.g. from photolithography. Within the proposed devices fluidic channels are arranged in a plurality of layers, the channels being interconnected between the various layers thus creating a 3D fluidic network.

WO 99/19717 or US 6 827 906 respectively proposes the production of 3D micro fluidic devices containing microstructure arrays. The transport of fluids through micro channels is achieved by means of electro osmotic flow or by means of electrophoresis. The micro fluidic devices are multilayer arrays, each layer being formed by a laminate continuously drawn from a roll and passed trough a process step for producing openings, reservoirs, flow channels, etc..

*Further, the* EP 1 542 010 *describes an analytical chip unit comprising various layers, through which a flow channel is extending. Through the flow channel, whose section is in closed shape, a fluid sample is made to flow for carrying out analyses regarding the fluid sample based on interaction between a predetermined substance and a specific substance, which is placed facing said flow channel. The chip further has a projection member attached to said flow channel. It is concluded that with the arrangement according to the* EP 1 542 010 *it becomes possible to analyse the fluid sample efficiently with high precision.*

The disadvantage of the known 3D microstructures and the processes for producing these 3D microstructures is that they can only by obtained by using various layers of 2D substrates or by complex processes such as several etching processes. With other words, the production costs for the known 3D microstructures are quite substantial.

Therefore one object of the present invention is to provide 3D micro fluidic structures consisting of a simple architecture or construction, respectively. A further object of the present invention is a method of producing 3D micro structures for micro fluidic devices by means of which 3D structures can be obtained with reduced costs.

In a first aspect, the present invention concerns a process for producing a micro fluidic device as defined in claim 1.

The inventive process for producing a micro fluidic device comprising a laminate structure or architecture made of individual laminate layers is characterised in that for creating at least one layer comprising a 3D structure within a preferably plane 2D layer a specific 2D pattern or 2D structure is produced by etching, punching, cutting, laser cutting, roll cutting or by any other suitable method followed by a mechanical and/or thermal forming procedure to create the 3D structure corresponding to the 2D pattern or 2D structure.

It is proposed, that the basic 2D layer is consisting of anisotropic substrate material on which the pattern for creating the 3D structure is created by means of an appropriate method such as punching, cutting, etching or the like and afterwards the substrate is formed by applying a force so that the structured basic pattern is forced out of the 2D substrate to create the 3D structure.

The forming of the 3D structure can be achieved mechanically or thermally or by another appropriate method.

The anisotropy which means the direction dependent property of the 2D substrate has to be such, that after forming, the initially created basic pattern on the substrate is forced out of the plane in that direction so that the 3D structure is influencing the micro fluidic channels within the at least one layer being arranged next to the further layer.

In a second aspect, the invention concerns a micro fluidic device as defined in claim 5. The microfluidic device being produced according to the process of claims 1 to 4.

The inventive micro fluidic device comprises a multilayer laminate structure or architecture, respectively, consisting of a plurality of individual layers of which at least one layer comprises a micro fluidic channel structure or micro fluidic channels and at least on one side of said layer a further layer comprising a so called 3D structure, the 3D structure influencing the flow characteristic within the micro fluidic channels or structures within the at least one layer.

The layer comprising the 3D structure is derived from a basic 2D layer consisting of an anisotropic material.

According to one possible design, the inventive micro fluidic device comprises at least four layers such as a base layer, the 3D structure containing further layer, the at least one layer comprising the micro fluidic channel structure or architecture, respectively, and a top layer, the base and/or the top layer containing at least one inlet and one outlet opening.

Further preferable designs of the inventive micro fluidic device are defined within the dependent claims.

According to one possible example of the present invention a substrate material can be used with different modules of elasticity, bending strength or thermic elongation coefficients on both sides or surfaces of the substrate. But it is also possible to use a substrate material which has other different physical properties on both sides such as e.g. different thermic conductivity of the substrate which can lead to different thermic forming by applying heat.

Again a further possibility is to use a material having different electric conductivity properties on both sides, so that by applying a current different heating is achieved on both sides of the substrate which can also lead to different thermal forming.

Again according to a further possibility of the present invention a layer substrate material can be used having an at least slightly enlarged thickness for the at least one further layer comprising the micro structure. Within the further layer with the slightly enlarged thickness a 3D pattern can be produced comprising holes, channels and the like by means of punching, cutting, etching, laser cutting and the like. The 3D characteristic of the further layer is achieved by the at least slightly enlarged thickness and the respective pattern like structure within the further layer.

Further embodiments of the inventive process are exemplified by the dependent claims.

The present invention shall be described in more details and by way of examples, which are shown within the attached drawings.

Within the figures:
Fig. 1 shows schematically four layers to be combined by lamination for the production of an example of an inventive micro fluidic device,
Fig. 2 shows schematically the lamination of the various layers of fig. 1 for producing the micro fluidic device,
Fig. 3 shows schematically the production of a 3D micro structure layer by deformation,
Fig. 4 shows a further possibility to produce a 3D micro structure layer by deformation,
Fig. 5 shows again a further possibility for the production of a 3D micro structure layer by deformation,
Fig. 6 again shows a further possibility of producing a 3D micro structure layer by deformation,
Fig. 7 again shows a further possibility of producing a 3D micro structure layer by deformation,
Fig. 8 shows an example of a 3D micro structure layer,
Fig. 9 shows an assembly of an inventive micro fluidic device including the 3D micro structure of fig.8,
Fig. 10 shows a further design of a 3D micro structure layer,
Fig. 11 again shows a further possible design of a 3D micro structure layer,
Fig. 12 shows a further example of a 3D micro structure layer,
Fig. 13a shows a further layer planned as 3D micro structure layer comprising a pre-structured substrate, with spots of e.g. detection chemistry.
Fig. 13b shows enlarged one portion of the 3D micro structure layer of fig. 13a after forming,
Fig. 14 shows a further possibility of producing a 3D micro structure by cutting a substrate layer with enlarged thickness,
Fig. 15 shows a further 3D micro structure based upon a substrate layer with enlarged thickness, and
Fig. 16 shows again a further example of a 3D micro structure based upon a substrate layer with enlarged thickness.

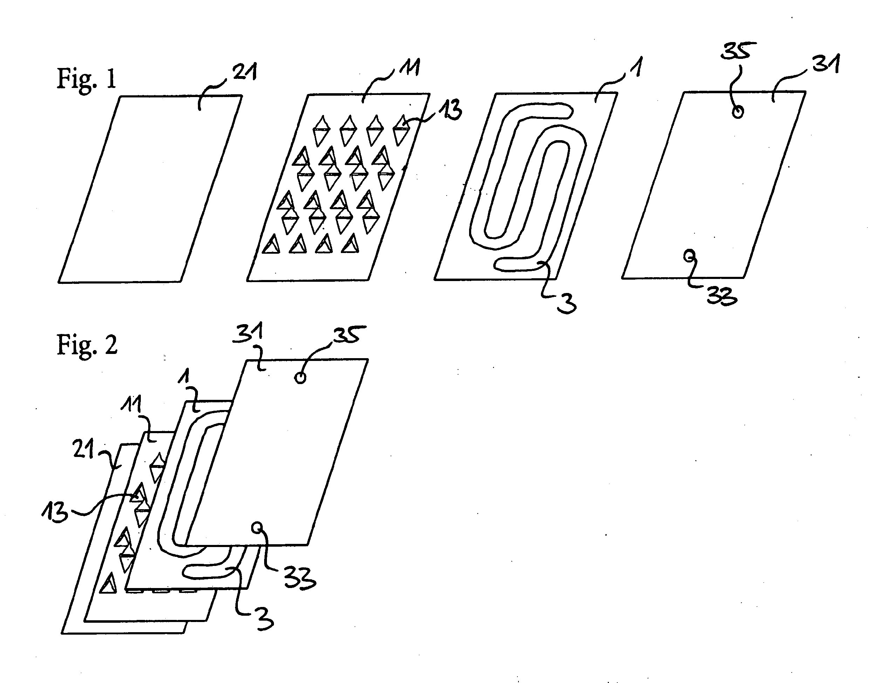

Fig. 1 shows schematically a possible example of a construction of a micro fluidic device consisting e.g. of four different layers such as a layer 1 comprising a micro fluidic channel structure 3 along which e.g. a sample fluid is flowing trough various sections, compartments, reservoirs, etc. to be treated in a predetermined manner. Next to the layer 1 with the micro fluidic channel a further layer 11 is shown comprising the 3D micro structure 13. These individual out of plane extending parts of the micro structure are influencing the flow characteristics of a fluid sample moving through the micro channels 3 within layer 1 to guarantee e.g. appropriate mixing of the fluid sample while flowing through the channel 3, dissolving of solid components within the fluid, influencing the flow resistance, etc....

Finally on both sides of the two layers 1 and 11 a top layer 31 and a base layer 21 are provided to finish the micro fluidic device on both sides. Within the top layer 31 an inlet 33 and an outlet opening 35 are provided for the introduction of the sample and for collecting the finally treated, reacted and/or analyzed test sample.

In fig. 2 it is schematically shown how the four layers 1, 11, 21 and 31 can be combined e.g. by laminating the individual layers.

The 3D structure may be produced first independently from the device comprising the micro fluidic channels out of a suitable 2D substrate such as e.g. a film or metal sheet according the inventive method and afterwards combined with the other layers to form the mentioned micro fluidic device. Of course, the 3D structure preferably is produced in correspondence with the design of the micro fluidic channels. With reference to the further figures, possible methods for structuring and forming the substrate to produce the 3D structure shall be described in detail. Common to all methods is that first the plane 2D substrate is structured by using a suitable method to create the basic form of the micro structures. Afterwards, according to one possible process, the substrate is formed so that the structured basic patterns are forced out of the 2D substrate to achieve the 3D structures. For structuring the substrate, various known methods are suitable such as e.g. etching, laser cutting, conventional cutting, punching, micro structured cutting by using a cutting role, etc.. The deformation of the 2D structures can be done either mechanically or thermally or by using other suitable methods. Basically, a preferably plane substrate is used, which may have anisotropic, direction dependent properties which means, properties responsible for creating a direction force which preferably is perpendicular to the plane of the substrate for the out of plane deformation of the created structure pattern within the plane substrate. Preferably, the anisotropy within the substrate is such that by applying a respective force the pre-structured pattern finally is forced towards the same side of the 2D substrate.

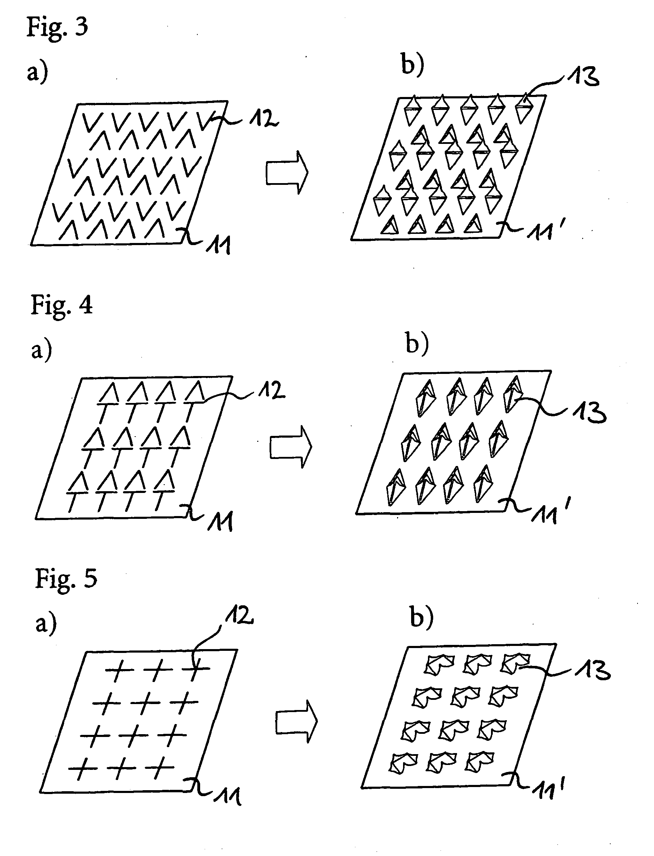

A possible deformation technique is mechanical forming, which is shown with respect to the following figures 3 to 7. Fig. 3a shows a plane 2D substrate 11, in which respective structured patterns 12 are created by a suitable method e.g. cutting. By applying a deformation force the pre-structured patterns 12 are forced out of the plane 11' for creating projecting parts 13 as shown in fig. 3b. The deformation can be achieved e.g. by a simple bending movement of the plane 11, by forcing the substrate 11 over a roll or an edge, or by applying a distortion force, etc..

In a similar manner again by a mechanical deformation the 3D structures 11' as shown in fig. 4b and fig. 5b can be achieved starting from the respective plane 2D substrate 11 as shown in fig. 4a and 5a.

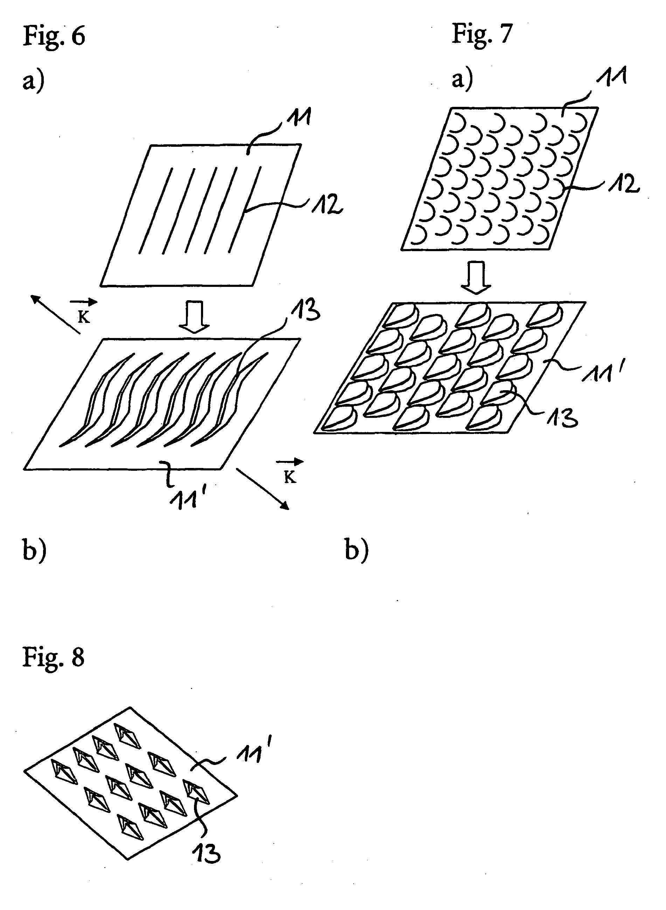

Again a mechanical deformation is responsible to achieve the 3D structures as shown in fig. 6b and 7b, where instead of a bending or distortion force an expansion force can be applied according the two arrows K as shown in fig. 6b. The basis for the 3D structure again is a plane 2D substrate 11, within which respective structures 12 are created, as shown in fig. 6a and 7a. But of course instead of an elongation force again a bending force could be applied which especially is possible for producing the 3D structure according fig. 7b.

An example in perspective view of a 3D structure is shown in fig. 8, where on a substrate plate 11' respective microstructures 13 are created.

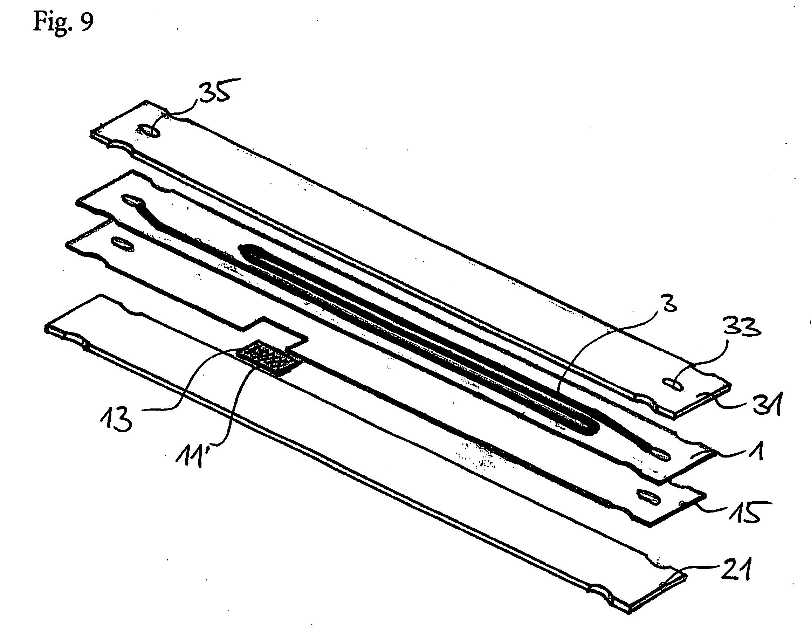

Fig. 9 shows an assembly of a practical example of a micro fluidic device corresponding to the devices as shown in figs. 1 and 2. The basis for the micro fluidic device again is one plane 2D sheet like layer 1, within which a pattern of a micro fluidic channel structure 3 is arranged. The micro fluidic channel structure consist of various channels, reservoirs, mixing areas, etc.. To influence the flow of a sample which is flowing along the channel path 3 within a further layer 15 3D micro structures 13 are arranged, which can be introduced within the further layer 15 by inserting the substrate 11' comprising the 3D micro structure 13 as shown in fig. 8. Finally the micro fluidic device according fig. 9 comprises a base layer 21 and a top layer 31, the latter comprising an inlet and outlet opening 35 and 33. Of course instead of only one 3D structure layer 11' further 3D structure layers could be arranged on the further layer 15 to influence the flow of the fluid sample along the channel or flow path 3.

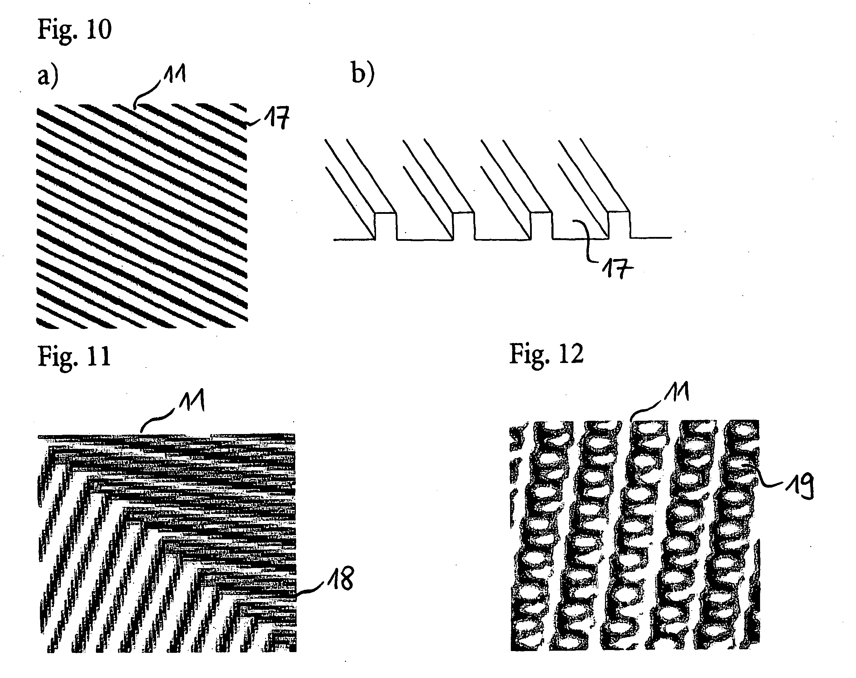

Instead of mechanically or thermally forming the plane 2D substrate 11 to achieve the 3D microstructure it is also possible to produce 3D structures by treating or processing one side of the plane substrate 11 by means of special tools as e.g. shaping tools to get a shaped structure 17 and 18 as shown schematically in fig.10 and 11. In fig. 10 crosswise grooves 17 are shown and in fig. 11 broken transverse grooves 18. The distance between the grooves maybe e.g. 10 - 100µm and the depths of the grooves may be e.g. 30µm. Typically, the angle of the grooves in fig. 11 may be e.g. 45°.

Instead of grooves it is also possible to have so called pillar arrays 19 as schematically shown in fig.12. Those pillar arrays maybe produced e.g. by etching according the process as used in photolithography. The distance between the individual pillars 19 may be e.g. 200µm, the diameter of the pillars may be e.g. 100µm, and the altitude of each individual pillar may be e.g. 50µm.

The shown structures with reference to the fig. 1 till 12 are generally used for micro fluidic devices. The 3D micro structures are preferably used in devices with a layered architecture which means devices with various layers. As described with reference to fig.1, 2 and 9, these devices are comprising a basis as bottom or base layer, a top layer, one or more layers with micro fluidic paths and one or more layers with the inventively described 3D structure.

The devices of the invention can preferably be used as:
- Mixing structures, e.g., so called herring bones, for homogenising a sample liquid with one or more solvents and/or reagents or for mixing two or more components or for forcing a specific flow rate of the sample liquid or for changing the flow resistance with in the channels.
- Dissolving structures which are structures which can cause a mass transfer in a perpendicular direction in respect to the flow direction of the sample liquid so that it can be achieved, that a e.g. dried up component sticking to the channel bottom of the micro fluidic channel can be homogeneously distributed over the whole channel square section. Furthermore by using the 3D micro structure it can be achieved in general that a solid component within the fluid channels can be better dissolved by a liquid sample or a dried component within the channel can be wetted and again be dissolved by using a solvent.
- Another effect of using the 3D micro structures is to influence the flow rate, the flow velocity or the flow resistance, respectively of fluid moving in a channel and to achieve a specific flowing profile within the micro fluidic channel.

E.g. dried up components within the middle of a channel can be dissolved by using microstructures without the danger, that influenced by capillary forces the components will be accumulated at the walls of the channel. Once accumulated components can only be extracted with difficulty from walls, as there the flow velocity is reduced due to a parabolic flow profile.

Dissolving structures as e.g. a pillar array as shown in fig. 12 can promote the dissolving of a dried up component within a channel, as the dried up component is not dried in the form of a compact volume. Due to the microstructure as the pillar array the dissolving area with the dried up component offers a plurality of contacting points for the solvent and, therefore, the dried up component can be faster dissolved as in case, that there is no structure.

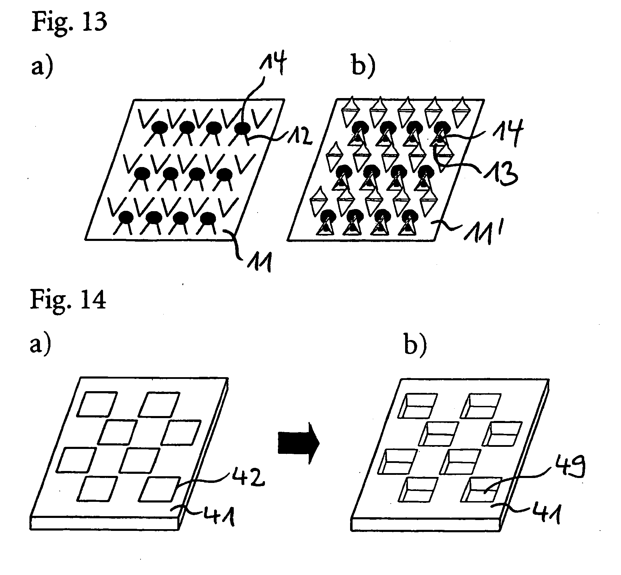

A further application is a micro optic application by creating a so called micro mirror array to achieve confocal-optical detection within a micro fluidic channel. In that respect we refer to figures 13a and 13b where another specific 3D micro structure is schematically shown. In fig. 13a on a plane substrate 11 a triangle like structured pattern 12 is shown comprising at the peak of each triangle a detection spot 14. By applying a bending or torsion force the individual triangles 12 are forced out of the plane 11 to create upwards bended triangle like portions 13 comprising at each peak the detection spot 14. By applying a special illumination procedure, e.g. a light beam in a specific angle to the bended portions 13 the light maybe reflected from the detection spots 14, so that the background signal of parts which are not bent gets reduced. An other way to reduce the background signal of the parts which are not bent is to focus with the detection optics on the bended portions only in a confocal way meaning that all the light out of the focus gets masked out.

By positioning the spot such as only a part of the spotted area covers the bended portion the active pot size (the part of the spot on the bended position) can be reduced in comparison to the total spotted area. This allows to create small active spots without the need to reduce the total size of the spotted area.

The fluid sample to be analyzed in the present invention can be e.g. a prepared human or animal body fluid such as e.g. blood.

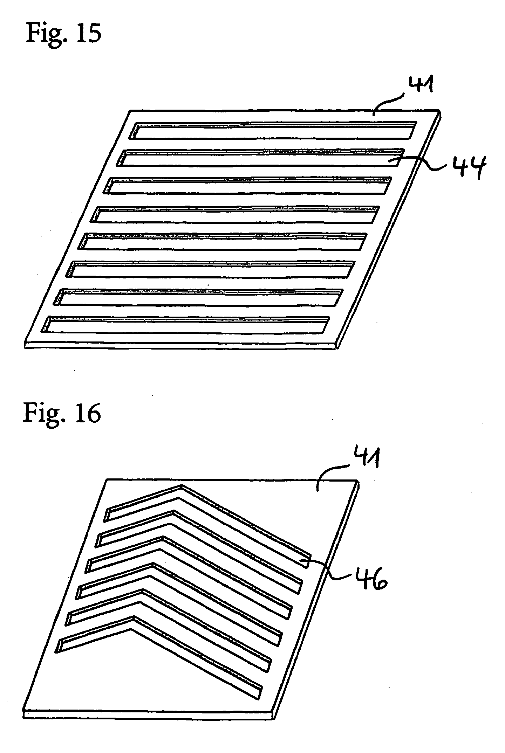

A further possibility to create a 3D micro structure is by using a further layer consisting of a layer thickness which is preferably substantially larger than the thickness of e.g. the layer comprising the micro fluidic channel. Respective examples of layers with an enlarged thickness are shown in fig. 14 to 16. Within a substrate 41 with an enlarged thickness, structure patterns 42 are created, e.g. by using a cutting knife, which are shown in fig. 14a. By punching out the created structure pieces 42 holes 49 within the substrate layer 41 are created as shown schematically in fig.14b. In a similar manner, micro structured 3D patterns 44 and 46 are created as shown schematically in fig. 15 and 16. Again the substrates as shown in fig. 14 to 16 can be combined with layers containing micro fluidic channels to produce micro fluidic devices similar to those described in figs. 1, 2 and 9. It goes without saying that the structures as shown in Fig. 14 - 16 can influence the flow of a liquid sample within a channel or path within a micro fluidic layer being placed next to the 3D structure e.g. on top of the 3D structure.

A great advantage of the present invention is that the 3D micro structures of a micro fluidic device have not to be aligned in a very precise and exact manner in relation to the channel containing layer. A 3D micro structure can be produced independently from channel containing structure. The two structures can then later be put together with an overlap of the two layers. This reduces the requirements for the alignment of the two layers during the assembly of the complete microfluidic device.

Figs. 1 to 16 only show and describe examples of 3D micro structures and of micro fluidic devices using an inventive 3D micro structure, and other designs and other combinations to produce micro fluidic devices are possible. Important is, that the 3D micro structure is produced within an individual layer and combined with other layers to a micro fluidic device. With other words, there is no need to build up various layers on one substrate e.g. using a plurality of etching steps as known e.g. in photolithography technique. Furthermore, not a plurality of layers have to be used to achieve the 3D structure, but the 3D structure is achieved by using one layer followed e.g. by a mechanical or thermal process as described above. Instead of a mechanical, thermal or chemical treatment it is also possible to use a substrate layer with an enlarged thickness to achieve the 3D structure.

By using the inventive method and the inventive 3D structures it is possible to achieve in a simple manner 3D multifunctional micro structures without the need to build up various layers by using masks as known within the state of the art. By using the proposed 3D micro structures lower production costs are possible for the production of micro fluidic devices. Furthermore according the demands of flow, flow rate, micro fluidic function, use of various fluid samples, use of dry components, chemical reactions etc. the 3D micro structures can be individually adapted in relation to the micro fluidic channels or the function of the structures.

## Claims

1. Process for producing a micro fluidic device comprising a laminate structure made of individual laminate layers, wherein for creating at least one layer (11) comprising a 3D structure (13) within a plane 2D layer a specific pattern or 2D structure is produced by etching, punching, cutting, laser cutting, roll cutting or by any other suitable method followed by a mechanical and/or thermal forming procedure to create the 3D structure corresponding to the 2D pattern or 2D structure, **characterized in that** the basic 2D layer for creating the 3D structure layer consists of an anisotropic material and the 2D layer is treated by mechanical or thermal forming such that as a result the 2D pattern or 2D structure is forced out of plane to form the 3D structure.

2. Process according to claim 1, **characterized in that** the 2D layer is bended, or forced over an edge, or rotated by applying a torsion force such that the initially created pattern or structure within the 2D layer is forced out of plane to create the 3D structure.

3. Process according to one of the claims 1 or 2, **characterized in that** at least one layer (11) containing the 3D structure (13) is combined with or arranged next to a layer (1) comprising a micro fluidic channel architecture (3) such that the 3D structure is influencing the flow of a fluid flowing trough the channels of the micro fluidic channels.

4. Process according to claim 3, **characterized in that** at least four layers are combined to produce the micro fluidic device, the four layers comprising a base layer (21), at least one layer comprising the micro fluidic channel architecture (1), at least one further layer comprising the 3D structure (11), and one top layer (31), the base layer and/or the top layer comprising at least one inlet opening and one outlet opening.

5. Micro fluidic device produced with a process according to one of the claims 1 to 4 comprising a laminate structure comprising a plurality of individual layers of which at least one layer (1) comprises a micro fluidic structure (3) or micro fluidic channel, **characterised in that** at least on one side of said layer a further layer (11) is arranged comprising a 3D structure (13), so that the 3D structure is influencing a flow characteristic of a fluid within the micro fluidic channel, the further layer comprising an anisotropic layer material and is derived from a 2D substrate.

6. Micro fluidic device according to claim 5, **characterized in that** the 3D structure within the further layer comprising an anisotropic layer material is achievable by means of mechanical forming or thermal forming of the 2D substrate.

7. Micro fluidic device according to claim 5, **characterized in that** the further layer containing the 3D structure comprises an increased thickness compared to the thickness of the other layers.

8. Micro fluidic device according to one of the claims 5 - 7, **characterized in that** the device comprises at least four layers such as a base layer (21), the 3D structure containing further layer (11), the at least one layer (1) comprising the micro fluidic structure and a top layer (31), the base and/or the top layer comprising at least one inlet and/or one outlet opening.

9. Micro fluidic device produced with a process according to one of the claims 1 to 4 comprising a laminate structure comprising a plurality of individual layers of which at least one layer (1) comprises a micro fluidic structure or micro fluidic channel (3), at least on one side of said layer a further layer (11) is arranged comprising a 3D structure (13) such that the 3D structure is influencing a flow characteristic of a fluid within the micro fluidic channel, **characterized in that** the 3D structure within the further layer is achievable by applying a bending or torsion force to a plane 2D structure layer comprising different physical and/or thermal behaviour on both sides of the layer such that by applying the bending force or torsion force the structure is forced out of the 2D plane for creating the 3D structure.

## Patentansprüche

1. Verfahren zur Herstellung einer mikrofluidischen Vorrichtung enthaltend eine Laminatstruktur hergestellt aus individuellen Laminatsschichten, wobei zur Herstellung mindestens einer Schicht (11) aufweisend eine 3D Struktur (13) in einer ebenen 2D Schicht ein spezifisches Muster oder eine 2D Struktur hergestellt wird durch Ätzen, Stanzen, Schneiden, Laserschneiden, Rollschneiden oder mittels irgendeiner anderen geeigneten Methode, gefolgt von einem mechanischen und/oder thermischen Formungsprozess um die 3D-Struktur herzustellen entsprechend dem 2D Muster oder der 2D Struktur, **dadurch gekennzeichnet, dass** die Basis 2D Schicht für das Herstellen der 3D-Struktur Schicht aus einem anisotropischen Material besteht und die 2D Schicht durch mechanisches oder thermisches Formen behandelt wird derart, dass als Resultat das 2D Muster oder die 2D Struktur aus der Ebene getrieben wird um die 3D Struktur zu bilden.

2. Verfahren nach Anspruch 1, **dadurch gekennzeichnet, dass** die 2D Schicht gebogen oder über eine Kante gezogen oder durch Anwendung einer Torsionskraft rotiert wird, derart, dass das ursprünglich hergestellte Muster oder die Struktur innerhalb der 2D Schicht aus der Ebene getrieben wird um die 3D Struktur zu bilden.

3. Verfahren nach einem Ansprüche 1 oder 2, **dadurch gekennzeichnet, dass** mindestens eine Schicht (11) enthaltend die 3D Struktur (13) mit einer Schicht (1) kombiniert oder nahe dieser angeordnet wird, enthaltend eine mikrofluidische Kanalarchitektur (3), derart, dass die 3D Struktur das Fliessen einer Flüssigkeit beeinflusst welche durch die Kanäle der mikrofluidischen fliesst.

4. Verfahren nach Anspruch 3, **dadurch gekennzeichnet, dass** mindestens vier Schichten kombiniert werden um die mikrofluidische Vorrichtung zu bilden, wobei die vier Schichten eine Basisschicht (21) mindestens eine Schicht enthaltend die mikrofluidische Kanalarchitektur (1), mindestens eine weitere Schicht enthaltend die 3D Struktur (11) und eine oberste Schicht (31) aufweist, wobei die Basisschicht und/oder die oberste Schicht mindestens eine Einlassöffnung und eine Auslauföffnung aufweisen.

5. Mikrofluidische Vorrichtung hergestellt mit einem Verfahren nach einem der Ansprüche 1 bis 4 enthaltend eine Laminatstruktur aufweisend eine Vielzahl von individuellen Schichten von welchen mindestens eine Schicht (1) eine mikrofluidische Struktur (3) oder einen mikrofluidischen Kanal aufweist, **dadurch gekennzeichnet, dass** auf mindestens einer Seite der besagten Schicht eine weitere Schicht (11) angeordnet ist enthaltend eine 3D Struktur (13), sodass die 3D Struktur die Fliesscharakteristik einer Flüssigkeit innerhalb des mikrofluidischen Kanals beeinflusst, wobei die weitere Schicht ein anisotropisches Schichtmaterial aufweist und aus einem 2D Substrat hergeleitet ist.

6. Mikrofluidische Vorrichtung nach Anspruch 5, **dadurch gekennzeichnet, dass** die 3D Struktur innerhalb der weiteren Schicht enthaltend ein anisotropisches Schichtmaterial erhältlich ist mittels mechanischen Formen oder thermischen Formen des 2D Substrates.

7. Mikrofluidische Vorrichtung nach Anspruch 5, **dadurch gekennzeichnet, dass** die weitere Schicht enthaltend die 3D Struktur eine grössere Dicke aufweist verglichen mit der Dicke der anderen Schichten.

8. Mikrofluidische Vorrichtung nach einem der Ansprüche 5 bis 7, **dadurch gekennzeichnet, dass** die Vorrichtung mindestens vier Schichten aufweist wie eine Basisschicht (21), die 3D Struktur enthaltende weitere Schicht (11) die mindestens eine Schicht (1) enthaltend die mikrofluidische Struktur und eine oberste Schicht (31) wobei die Basis und/oder die oberste Schicht mindestens eine Einlass- und/oder eine Auslassöffnung aufweisen.

9. Mikrofluidische Vorrichtung hergestellt mittels einem Verfahren nach einem der Ansprüche 1 bis 4 enthaltend eine Laminatstruktur aufweisend eine Vielzahl von individuellen Schichten von welchen mindestens eine Schicht (1) eine mikrofluidische Struktur oder einen mikrofluidischen Kanal (3) aufweist, mindestens auf einer Seite der besagten Schicht eine weitere Schicht (11) angeordnet ist aufweisend eine 3D Struktur (13) derart dass die 3D Struktur eine Fliesscharakteristik einer Flüssigkeit innerhalb des mikrofluidischen Kanals beeinflusst **dadurch gekennzeichnet, dass** die 3D Struktur innerhalb der weiteren Schicht erhältlich ist durch das Anwenden einer Biege- oder Torsionskraft an eine ebene 2D Struktur Schicht enthaltend unterschiedliches physikalisches und/oder thermisches Verhalten auf beiden Seiten der Schicht derart, dass durch das Anwenden der Biegekraft oder Torsionskraft die Struktur aus der 2D Ebene getrieben wird für die Herstellung der 3D Struktur.

## Revendications

1. Procédé pour produire un dispositif microfluidique comprenant une structure stratifiée constituée de couches stratifiées individuelles, dans lequel pour créer au moins une couche (11) comprenant une structure en 3D (13) au sein d'une couche en 2D plane, un motif spécifique ou structure en 2D est produit par gravure, poinçonnage, découpe, découpe au laser, découpe à la guillotine ou par tout autre procédé approprié suivi d'une procédure de formage mécanique et/ou thermique pour créer la structure en 3D correspondant au motif en 2D ou structure en 2D, **caractérisé en ce que** la couche en 2D de base pour créer la couche de structure en 3D consiste en un matériau anisotrope et la couche en 2D est traitée par formage mécanique ou thermique de telle sorte qu'en résultat, le motif en 2D ou structure en 2D est forcé hors du plan pour former la structure en 3D.

2. Procédé selon la revendication 1, **caractérisé en ce que** la couche en 2D est fléchie, ou forcée sur un bord, ou tournée en appliquant une force de torsion de telle sorte que le motif ou structure initialement créé au sein de la couche en 2D est forcé hors du plan pour créer la structure en 3D.

3. Procédé selon l'une quelconque des revendications 1 ou 2, **caractérisé en ce qu'**au moins une couche (11) contenant la structure en 3D (13) est combinée avec une, ou agencée à côté d'une, couche (1) comprenant une architecture de canaux microfluidiques (3) de telle sorte que la structure en 3D a une influence sur l'écoulement d'un fluide s'écoulant à travers les canaux des canaux microfluidiques.

4. Procédé selon la revendication 3, **caractérisé en ce qu'**au moins quatre couches sont combinées pour produire le dispositif microfluidique, les quatre couches comprenant une couche de base (21), au moins une couche comprenant l'architecture de canaux microfluidiques (1), au moins une autre couche comprenant la structure en 3D (11), et une couche supérieure (31), la couche de base et/ou la couche supérieure comprenant au moins une ouverture d'entrée et une ouverture de sortie.

5. Dispositif microfluidique produit par un procédé selon l'une des revendications 1 à 4 comprenant une structure stratifiée comprenant une pluralité de couches individuelles dont au moins une couche (1) comprend une structure microfluidique (3) ou canal microfluidique, **caractérisé en ce qu'**au moins sur un côté de ladite couche une autre couche (11) est agencée, comprenant une structure en 3D (13), de telle sorte que la structure en 3D a une influence sur une caractéristique d'écoulement d'un fluide à l'intérieur du canal microfluidique, l'autre couche comprenant un matériau de couche anisotrope et est obtenue à partir d'un substrat en 2D.

6. Dispositif microfluidique selon la revendication 5, **caractérisé en ce que** la structure en 3D au sein de l'autre couche comprenant un matériau de couche anisotrope est réalisable au moyen d'un formage mécanique ou d'un formage thermique du substrat en 2D.

7. Dispositif microfluidique selon la revendication 5, **caractérisé en ce que** l'autre couche contenant la structure en 3D comprend une épaisseur augmentée par rapport à l'épaisseur des autres couches.

8. Dispositif microfluidique selon l'une des revendications 5 à 7, **caractérisé en ce que** le dispositif comprend au moins quatre couches telles qu'une couche de base (21), l'autre couche (11) contenant la structure en 3D, l'au moins une couche (1) comprenant la structure microfluidique et une couche supérieure (31), la couche de base et/ou la couche supérieure comprenant au moins une ouverture d'entrée et/ou une ouverture de sortie.

9. Dispositif microfluidique produit par un procédé selon l'une des revendications 1 à 4 comprenant une structure stratifiée comprenant une pluralité de couches individuelles dont au moins une couche (1) comprend une structure microfluidique ou canal microfluidique (3), au moins sur un côté de ladite couche une autre couche (11) est agencée, comprenant une structure en 3D (13), de telle sorte que la structure en 3D a une influence sur une caractéristique d'écoulement d'un fluide à l'intérieur du canal microfluidique, **caractérisé en ce que** la structure en 3D au sein de l'autre couche est réalisable en appliquant une force de flexion ou de torsion à une couche de structure en 2D plane comprenant un comportement physique et/ou thermique différent sur les deux côtés de la couche, de telle sorte qu'en appliquant la force de flexion ou la force de torsion, la structure est forcée hors du plan en 2D pour créer la structure en 3D.
